# EUROPÄISCHE PATENTSCHRIFT

(11) **EP 3 543 821 B1**
(45) Veröffentlichungstag und Bekanntmachung des Hinweises auf die Patenterteilung: **18.11.2020**
(21) Anmeldenummer: 18163373.6
(22) Anmeldetag: 22.03.2018
(51) Int. Cl.: G06F 1/16, G02F 1/1333

(54) **RAHMEN FÜR EIN EIN- UND AUSGABEGERÄT UND VERFAHREN ZUM HERSTELLEN EINES RAHMENS**
FRAME FOR AN INPUT/OUTPUT DEVICE AND METHOD FOR PRODUCING A FRAME
CADRE POUR UN APPAREIL D'ENTRÉE ET DE SORTIE ET PROCÉDÉ DE FABRICATION D'UN CADRE

(43) Veröffentlichungstag der Anmeldung: 25.09.2019
(73) Patentinhaber: Siemens Aktiengesellschaft, 80333 München (DE)
(72) Erfinder: Daubenmerkl, Christian, 92256 Hahnbach (DE); Hummel, Alfredo, 93133 Burglengenfeld (DE); Krieger, Harald, 91284 Neuhaus (DE); Ringer, Ulrich, 92224 Amberg (DE); Schlichting, Heinrich, 93173 Wenzenbach (DE); Traub, Andreas, 92224 Amberg (DE)

(56) Entgegenhaltungen:
- EP-A1- 2 881 781
- CN-A- 102 256 456
- JP-A- 2014 063 195
- US-A1- 2014 055 929

## Beschreibung

Die Erfindung betrifft einen Rahmen für ein Ein- und Ausgabegerät mit vier Ecken sowie ein Ein- und Ausgabegerät für den industriellen Einsatz mit diesem Rahmen, aber auch ein Verfahren zur Herstellung eines Rahmens für ein Ein- und Ausgabegerät, wobei ein Rahmenprofil verwendet wird, welches einen ersten Schenkel und einen zweiten Schenkel aufweist, wobei am ersten Schenkel ein Band und am zweiten Schenkel eine Nut angeordnet ist.

Ein Großteil von modernen Ein- und Ausgabegeräten, welche eine Mensch-Maschine-Schnittstelle oder auch ein Human-Machine-Interface (HMI) aufweisen, basieren auf einer Kombination aus einem Display und einer Touch Screen-Technologie als Ein- und Ausgabeeinheiten.

Gerade durch die Verwendung von Ein- und Ausgabegeräten im Zusammenhang mit der industriellen Nutzung sind die Anforderungen an derartige Geräte im industriellen Umfeld im Bezug auf mechanische Robustheit und Widerstandsfähigkeit gegenüber den äußeren Einflüssen und Gegebenheiten entsprechend gestiegen. Diese Anforderungen können in keiner Weise mit den Anforderungen an herkömmliche Ein- und Ausgabegeräte, insbesondere Displays wie sie z.B. im privaten Umfeld bei Monitoren und Fernsehgeräten vorkommen, verglichen werden.

Üblicher Weise werden Ein- und Ausgabegeräte für den industriellen Einsatz derart ausgeführt, dass entsprechend stabile und widerstandsfähige Gehäuse bzw. Rahmen für diese Ein- und Ausgabegeräte vorgesehen werden. Aus diesem Grund werden Geräterahmen für industriell genutzte Ein- und Ausgabegeräte, vorzugsweise aus Metall, insbesondere aus Aluminium, gefertigt.

Weiterhin gibt es Anforderungen an eine Dichtheit hinsichtlich Staub und Spritzwasser. Im industriellen Umfeld muss ein Display, beispielsweise bei der Reinigung einer Maschine, eine Spritzwasser- oder Strahlwasserbelastung standhalten können. Oft werden auch Anforderungen hygienischer Natur gestellt. Hier geht es insbesondere darum, Möglichkeiten für eine Schmutzablagerung am Display weitestgehend zu unterbinden. Dabei sollten vor allem Rillen, Spalten und Vertiefungen am Display bzw. am Displayrahmen vermieden werden.

Um all diese Anforderungen erfüllen zu können, werden nach derzeitigem Stand der Technik Ein- und Ausgabegeräte mit einem Display für industrielle Anwendungen, vorzugsweise mit einem einteiligen, das Display aufnehmenden Rahmen, gefertigt. Zum einen können diese einteilige Rahmen mit einem Spritzgussverfahren mit einer Form als Werkzeug hergestellt werden oder aus dem Vollen, beispielsweise durch Fräsen, gefertigt werden. Hierbei kommt es zum einen naturgemäß zu sehr hohen Materialverlusten, was die Kosten für solche Displayrahmen erhöht und auch die Fertigung aufwändig und ineffizient macht. Bei einem Spritzgussverfahren in einer Form für einen Rahmen sind enorme Kosten für ein Spritzgusswerkzeug im Vorfeld bereitzustellen. Hat man nun nur eine geringe Stückzahl für Ein- und Ausgabegeräte mit einem derartigen Rahmen, so sind die bisherigen bekannten Fertigungsverfahren nicht mehr wirtschaftlich.

Aus der CN 28 449 70 Y ist ein Rahmen für ein LCD-Display bekannt, welcher aus einzelnen Rahmenteilen zusammengesetzt wird.

Aus der KR 10 2005 0027375 A ist ein Rahmen für ein Flachdisplay bekannt, der aus einzelnen Rahmenteilen zusammengesetzt ist.

Aus der EP 3 106 915 A1 ist ebenfalls ein Rahmen, welcher aus einzelnen Profilteilen zusammengesetzt wird, bekannt.

Aus der US 2014/055929 A1 und aus der EP 2 881 781 A1 ist ein Rahmen für ein Flachdisplay bekannt, der aus einem einstückig ausgebildeten Rahmenprofil besteht. Zur Verstärkung des Rahmens sind vier an den Ecken angebrachten Eckelemente.

Es ist Aufgabe der vorliegenden Erfindung einen Rahmen für ein Ein- und Ausgabegerät, vorzugsweise für den industriellen Einsatz, möglichst kostengünstig herzustellen, und zudem auf zusätzliche Spalten oder Rillen in den Rahmen zu verzichten.

Diese Aufgabe wird erfindungsgemäß dadurch gelöst, dass ein Rahmen für ein Ein- und Ausgabegerät mit vier Ecken bereitgestellt wird, wobei ein einstückig ausgebildetes Rahmenprofil verwendet wird. Das Rahmenprofil weist einen ersten Schenkel und einen zweiten Schenkel auf, wobei am ersten Schenkel ein Band angeordnet ist, und wobei in dem Rahmenprofil zur Ausbildung der vier Ecken Freiräume derart angeordnet sind, dass das Band im Bereich der Freiräume stehen bleibt, und am zweiten Schenkel eine Nut angeordnet ist, wobei in den Ecken jeweils ein Eckelement angeordnet ist, und das Eckelement einen Elementkörper mit einem ersten Elementschenkel und einem zweiten Elementschenkel aufweist, wobei die Elementschenkel im Wesentlichen rechtwinklig zueinander am Elementkörper angeordnet sind und die Eckelemente derart in den Freiräumen angeordnet sind, dass der erste Elementschenkel und der zweite Elementschenkel jeweils in der Nut des Rahmenprofils angeordnet sind. Ein derartiger Rahmen hat den Vorteil, dass er einstückig ausgebildet ist und nicht, wie nach dem Stand der Technik, aus vier einzelnen Rahmenelementen besteht. Wird das einstückige Rahmenprofil zu einem Rahmen mit Ecken gebogen, so müssen die Ecken überbogen werden um eine Restspannung im Material zu überwinden und damit ein rückfedern der Seiten des Rahmens zu verhindern. Wenn die angegebenen Freiräume entsprechend großzügig in dem Rahmenprofil freigefräst wurden, ist ein Überbiegen der Ecken ohne eine spätere Rückfederung möglich. Das spätere Einstecken der Eckelemente bringt dem Rahmen die erforderliche Stabilität.

In einer weiteren Ausgestaltung der Erfindung sind die Eckelemente derart ausgestaltet, dass die Elementschenkel an einem unteren Ende des Elementkörpers und ein Elementkopf an einem oberen Ende des Elementkörpers angeordnet sind. Dabei ist der Elementkörper am Kopf derart ausgestaltet, dass er den Freiraum in den Ecken derart verschließt, dass auf dem ersten Schenkel innerhalb des Rahmens eine ebene Fläche zum Aufbringen einer Dichtung und/oder Klebefläche zum späteren Einsetzen einer Berührfläche vorhanden ist. Der Elementkopf ist somit derart ausgestaltet, dass er bündig bis an das Band reicht und bereits eine Vorstufe für eine durchgängige Klebefläche oder Gerätedichtungsmontagefläche bereitstellt, hierdurch wird z.B. eine Dichtigkeit nach der Norm IP 65 oder vergleichbar ermöglicht.

Vorteilhafterweise ist das Band als ein oberer Umfangskragen für den Rahmen ausgestaltet und in diesem oberen Umfangskragen ist die Dichtung angeordnet, welche den Zwischenraum zwischen der Fläche des ersten Schenkels und einer Randfläche der später einsetzbaren Berührfläche abdichtet.

Weiterhin ist es von Vorteil, wenn das Band zusätzlich als ein unterer Umfangskragen für den Rahmen ausgestaltet ist und in diesem unteren Umfangskragen eine weitere Dichtung angeordnet ist, welche den Zwischenraum zwischen einer unteren Fläche des ersten Schenkels und einer Randfläche eines Einbauausschnittes abdichtet. Wird nun der Rahmen in einen Einbauausschnitt montiert, so kann mit der weiteren Dichtung der Rahmen beispielsweise in einer Wandmontage zu der Wand abgedichtet werden.

Vorteilhafterweise weist das Rahmenprofil im zweiten Schenkel eine Halte-Nut mit einer Hinterschneidung auf, um in der Halte-Nut eine Klemme für einen Einbau in den Einbauausschnitt zu befestigen. Die Klemme würde bei einer Wandmontage gegen das Innere der Wand drücken und den Rahmen so fest in dem Einbauausschnitt halten.

Eine besonders günstige Fertigung eines Rahmenprofils wird durch eine Aluminium-Stranggussprofilfertigung erreicht.

Der eingangs aufgezeigte Rahmen wird mit Vorteil bei einem Ein- und Ausgabegerät für den industriellen Einsatz eingesetzt.

Das erfindungsgemäße Verfahren zeichnet sich dadurch aus, dass ein Rahmenprofil verwendet wird, welches einstückig ausgestaltet ist. Bei dem Verfahren zur Herstellung des Rahmens für ein Ein- und Ausgabegerät, wird ein Rahmenprofil verwendet, welches einen ersten Schenkel und einen zweiten Schenkel aufweist, wobei am ersten Schenkel ein Band und am zweiten Schenkel eine Nut angeordnet ist, wobei in einem ersten Schritt eine Länge, welche dem späteren Umfang des Rahmens entspricht, von einem Rahmenprofil abgelängt wird, und in einem zweiten Schritt entsprechend der späteren Seitenlängen des Rahmens werden in das Rahmenprofil zur Ausbildung der vier Ecken Freiräume derart eingebracht, dass das Band im Bereich der durch die Freiräume entstandenen Ausschnitte stehen bleibt, die Größe der Freiräume wird dabei derart gewählt, dass ein im nächsten Schritt erforderliches Überbiegen störungsfrei gelingen kann, in einem dritten Schritt werden an den Stellen der Freiräume die Ecken gebogen, dabei werden die jeweils an einer Ecke anliegenden Seiten leicht über einen Winkel von 90° Grad hinweg überbogen, um eine Restspannung im Material zu überwinden und damit ein Rückfedern der Seiten zu verhindern, in einem vierten Schritt wird dann in den Ecken jeweils ein Eckelement eingesetzt, wobei das Eckelement einen Elementkörper mit einem ersten Elementschenkel und einem zweiten Elementschenkel aufweist, wobei die Elementschenkel im Wesentlichen rechtwinklig zueinander am Elementkörper angeordnet sind und die Eckelemente derart in die Freiräume eingesetzt werden, dass der erste Elementschenkel und der zweite Elementschenkel jeweils in der Nut des Rahmenprofils angeordnet wird, anschließend wird ein verbleibender Stoß zusammengeschweißt. Auf vorteilhafte Weise ist nun ein Rahmen entstanden, welcher insbesondere an den Ecken keine Rillen und Kanten sondern ein ansprechendes modernes Design aufweist.

Bei einem weiteren Verfahrensschritt wird vorteilhafter Weise ein Eckelement verwendet, bei welchem die Elementschenkel an einem unteren Ende des Elementkörpers und ein Elementkopf an einem oberen Ende des Elementkörpers angeordnet sind, wobei der Elementkopf derart in dem Freiraum in den Ecken platziert wird, dass er diesen bündig verschließt, damit auf dem ersten Schenkel innerhalb des Rahmens eine ebene Fläche zum Aufbringen einer Dichtung und/oder Klebefläche zum späteren Einsetzen einer Berührfläche geschaffen wird.

Das vorgeschlagene Verfahren hat mehrere Vorteile gegenüber dem bekanntgewordenen Herstellungsverfahren nach dem Stand der Technik. So kann zum einen auf ein aufwändiges Druckgussverfahren verzichtet werden und zum anderen müssen für einzelne unterschiedliche Rahmengrößen keine eigenen Druckgusswerkzeuge angeschafft werden. Durch die obige vorgeschlagene verfahrensgemäße Lösung lassen sich Rahmen für Frontrahmen für Displays in jeder beliebigen Größe herstellen. Die Verwendung von Druckgusswerkzeugen ist nicht notwendig, so dass letztendlich die Kosten für die Herstellung eines einzelnen Rahmens erheblich reduziert werden.

Mit der Zeichnung wird ein Ausführungsbeispiel der Erfindung vorgestellt. Es zeigen:
- FIG 1: ein Ein- und Ausgabegerät in Form eines Touch-Panel PC,
- FIG 2: ein bereits gebogener Rahmen mit vier Ecken,
- FIG 3: ein sich längs erstreckendes Rahmenprofil mit entsprechenden ausgeschnittenen Freiräumen,
- FIG 4: ein ausgeschnittener Freiraum im Rahmenprofil als Detaildarstellung,
- FIG 5: der in FIG 4 gezeigte ausgeschnittene Freiraum in einer anderen Darstellung,
- FIG 6: eins von vier Eckelementen,
- FIG 7: einen Ausschnitt aus dem Rahmen im Querschnitt zur Verdeutlichung der Struktur des Rahmenprofils,
- FIG 8: einen Ausschnitt des Rahmens der Ecke A zur Verdeutlichung des eingesetzten Eckelementes,
- FIG 9: das in FIG 8 gezeigte Eckelement mit einer darüber angeordneten Dichtung,
- FIG 10: das Ein- und Ausgabegerät in einer Schnittdarstellung, und
- FIG 11: das Ein- und Ausgabegerät in einer perspektivischen Rückansicht mit Darstellung von Halte- bzw. Montageflächen.

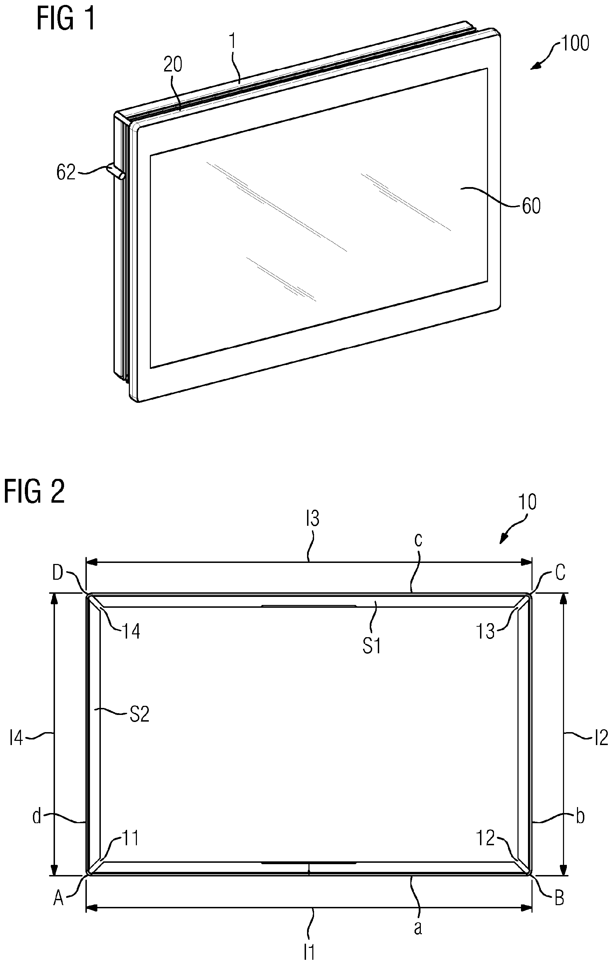

Gemäß der FIG 1 ist ein Ein- und Ausgabegerät 100 in Form eines Touch-Panel PC dargestellt. Das Ein- und Ausgabegerät 100 weist eine Berührfläche 60 als Touch-Screen auf. Der Touch-Screen ist in einem Rahmen 1, welcher aus einem Rahmenprofil 10 gefertigt ist, eingefasst. Für eine spätere Montage in einen Einbauausschnitt ist in das Rahmenprofil eine Haltenut 22 eingearbeitet, in der eine Klemme 62 angeordnet ist.

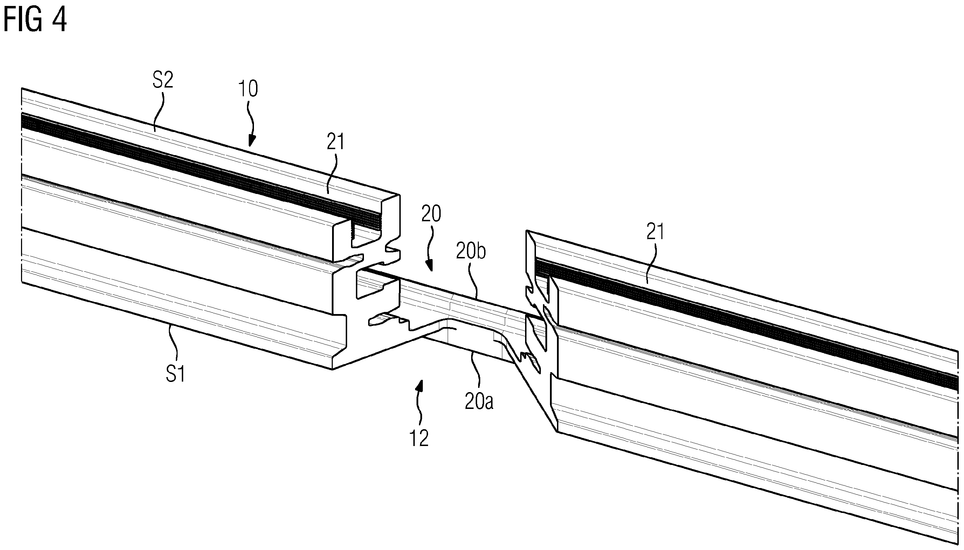

Mit der FIG 2 ist ein Rahmen 1 für das gemäß FIG 1 gezeigte Ein- und Ausgabegerät 100 mit vier Ecken A,B,C,D gezeigt. Erfindungsgemäß ist das Rahmenprofil 10 einstückig ausgebildet, dabei weist das Rahmenprofil 10 einen ersten Schenkel S1 und einen zweiten Schenkel S2 auf. Am ersten Schenkel S1 ist ein flaches Band 20 angeordnet. Das Band 20 dient später als umlaufende abgerundete Gerätekante. In dem Rahmenprofil 10 sind zur Ausbildung der vier Ecken A,B,C,D Freiräume 11,12,13,14 derart angeordnet, dass das Band 20 im Bereich der Freiräume 11,12,13,14 stehen bleibt. Am zweiten Schenkel S2 ist eine Nut 21 angeordnet (siehe FIG 4).

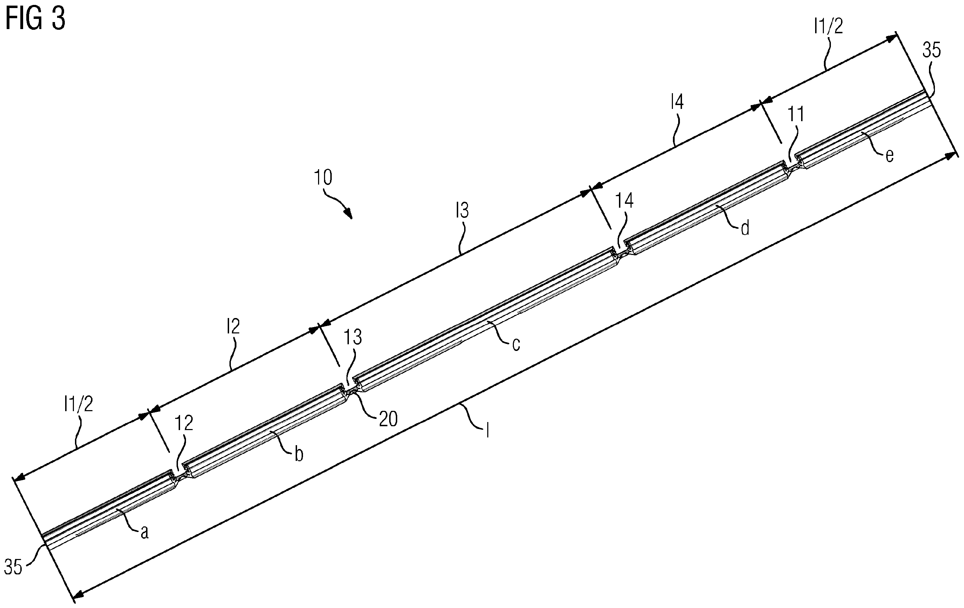

Die Herstellung eines Rahmen 1 gemäß FIG 2 wird nachfolgend anhand der FIG 3 erläutert. Gemäß FIG 3 ist ein sich längs erstreckendes Rahmenprofil 10 gezeigt. Das Rahmenprofil 10 weist eine Gesamtlänge l auf, welche dem späteren Umfang des Rahmens 1 entspricht. Demnach ist das Rahmenprofil 10 nun in fünf Abschnitte unterteilt. Der erste Abschnitt und der letzte Abschnitt sind jeweils die Hälfte einer ersten Seite a lang und sind damit halb so lang wie die Länge l1. Der zweite Abschnitt entspricht der Seite b und hat die Länge l2. Der dritte Abschnitt entspricht der dritten Seite c und hat die Länge l3 und der vierte Abschnitt entspricht der Seite d und hat die Länge l4. Verfahrensgemäß wurde demnach eine Länge l, welche den späteren Umfang des Rahmens 1 entspricht, von einem Rahmenprofil 10 abgelängt. Danach werden entsprechend der späteren Seitenlängen l1, l2, l3, l4 des Rahmens 1 in das Rahmenprofil 10 zur Ausbildung der vier Ecken A,B,C,D Freiräume 11,12,13,14 derart eingebracht, dass das Band 20 im Bereich der durch die Freiräume 11,12,13,14 entstandenen Ausschnitte stehen bleibt. Die Größe der Freiräume 11,12,13,14 wird dabei derart gewählt, dass das in einen nächsten Schritt erforderliches Überbiegen störungsfrei gelingen kann.

Mit der FIG 4 ist beispielhaft in einer Detaildarstellung der zur zweiten Ecke B zugehörige zweite Freiraum 12 dargestellt. Das Rahmenprofil 10 zeigt hier deutlicher den ersten Schenkel S1 und den zweiten Schenkel S2. Im Wesentlichen wird das Material aus dem Rahmenprofil 10 für den Freiraum 12 derart ausgefräst, dass das umlaufende Band 20, als späterer abgerundeter Rahmen stehen bleibt. Der Freiraum 12 wird als ein Segment aus dem Rahmenprofil 10 ausgefräst. Das Band 20 bildet somit einen oberen Umfangskragen 20a und einen unteren Umfangskragen 20b. Des Weiteren weist das Rahmenprofil 10 die bereits angesprochene Nut 21 für das spätere Einstecken eines Eckelementes 32 auf.

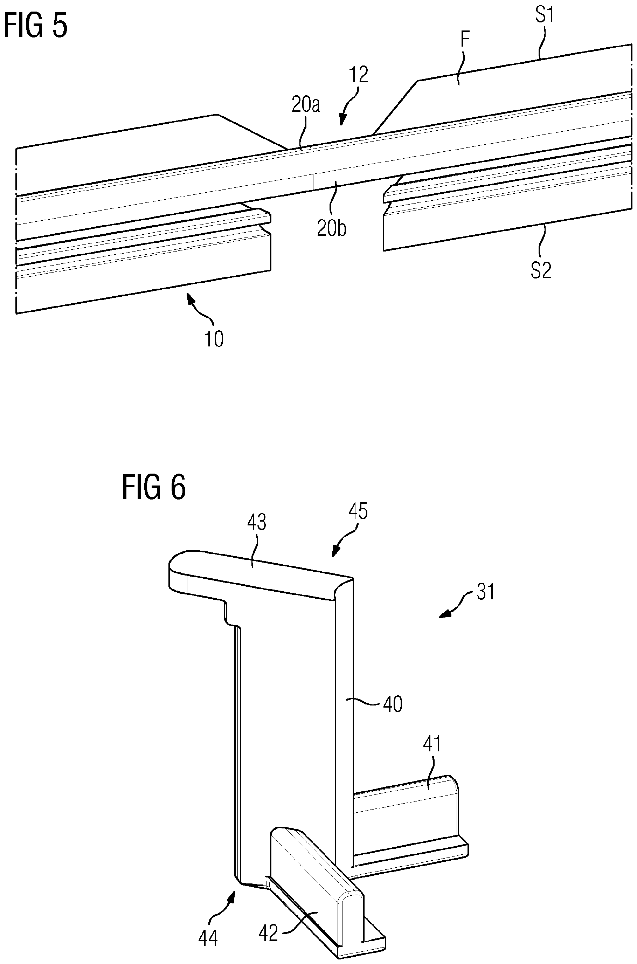

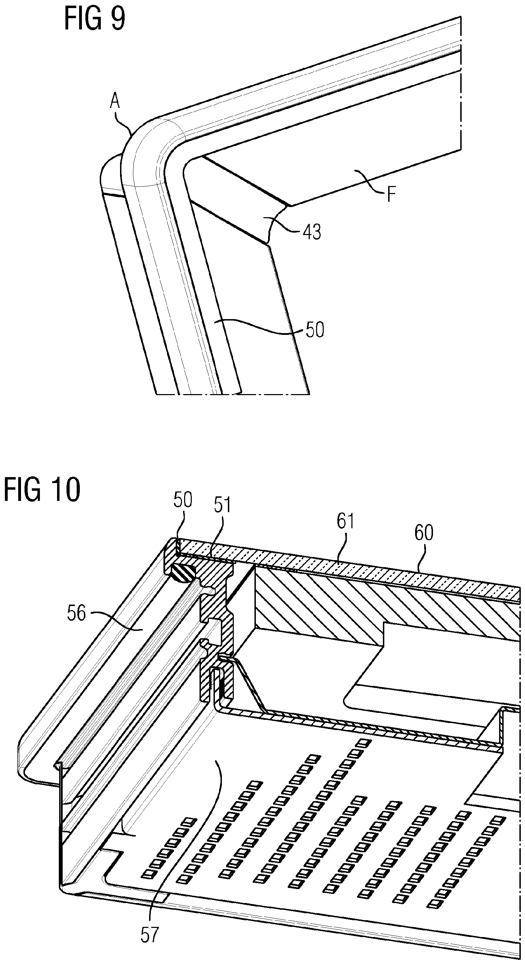

Die FIG 5 zeigt die aus FIG 4 bekannte Detaildarstellung in einer anderen Ansicht. Hier ist noch einmal sichtbar, dass das Band 20 einen oberen Umfangskragen 20a und einen unteren Umfangskragen 20b bildet, wobei das Band 20 in seiner äußeren Kontur abgerundet ausgeformt ist. Eine Fläche F des ersten Schenkels S1 bildet später eine Fläche F zum Aufbringen einer Dichtung 50 und/oder einer Klebefläche 51 zum Einsetzen einer Berührfläche 60. Die Berührfläche 60 entspricht dann beispielsweise dem zu einem Display 61 (siehe FIG 10) vorgelagerten Touch-Screen.

Gemäß FIG 6 ist das erste Eckelement 31 dargestellt. Die Eckelemente 31,32,33,34 werden in den Freiräumen 11,12,13,14 des gebogenen Rahmenprofils 10 angeordnet und erhöhen damit die Stabilität des Rahmens 1. Das Eckelement 31 weist einen Elementkörper 40 mit einem ersten Elementschenkel 41 und einem zweiten Elementschenkel 42 auf. Die Elementschenkel 41,42 sind im Wesentlichen rechtwinklig zueinander an einem unteren Ende 44 des Elementkörpers 40 angeordnet. An einem oberen Ende 45 des Elementkörpers 40 ist ein Elementkopf 43 angeordnet. Der Elementkopf 43 dient im eingesteckten Zustand in den Rahmen dem Verschließen der durch das Ausfräsen des Rahmenprofils 10 entstandenen Freiräume 11,12,13,14. Dadurch, dass seine Elementschenkel 41,42 in der Nut 21 des Rahmenprofils 10 verkeilt sind, wird weiterhin Stabilität des Rahmens 1 erhöht.

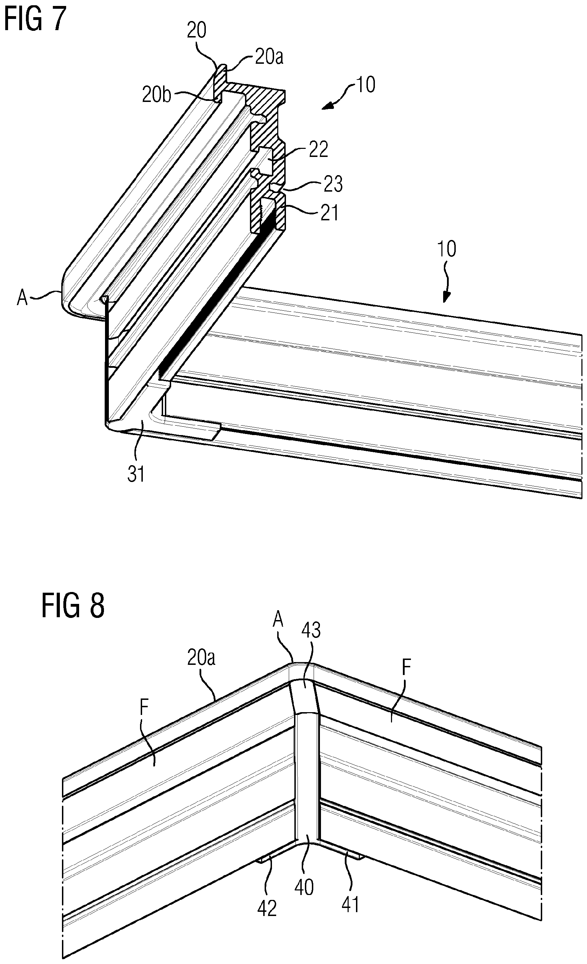

Die FIG 7 zeigt den Rahmen 1 mit dem Rahmenprofil 10 in einer perspektivischen Querschnittsdarstellung. In der ersten Ecke A ist ein erstes Eckelement 31 eingesetzt. Der Schnitt durch das Rahmenprofil 10 zeigt das umlaufende Band 20 mit seinem oberen Umfangskragen 20a und seinem unteren Umfangskragen 20b. Die in dem zweiten Schenkel eingebrachte Haltenut 22 weist eine Hinterschneidung auf, um später in dieser Haltenut 22 eine Klemme 62 befestigen zu können. In die Nut 21 kommen nicht nur an den Ecken die Elementschenkel 41,42 zu liegen, sondern es kann auch abschließend eine Rückwandhaube 57 (siehe FIG 10), welche aus einem an den Rändern umgebogenen Blech bestehen kann, in die Nut 21 eingesteckt werden.

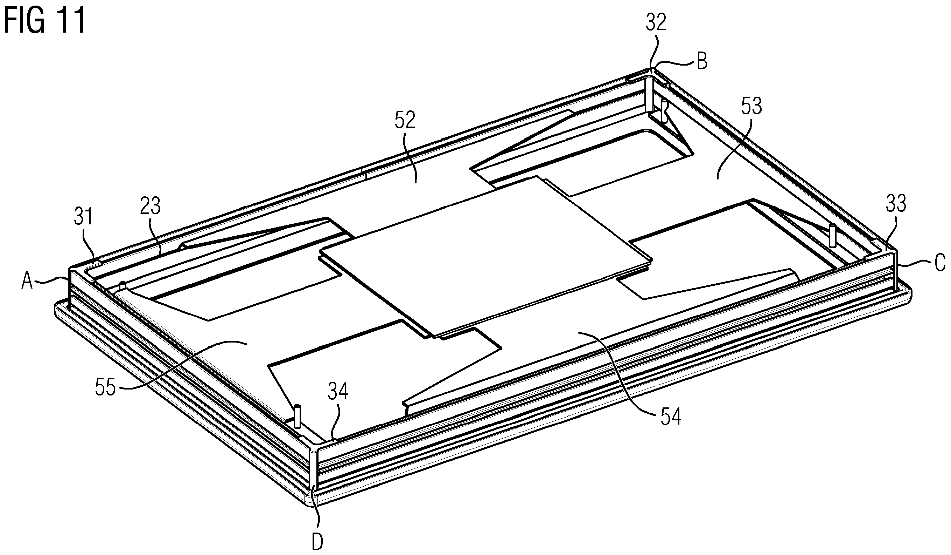

Zusätzlich weist das Rahmenprofil 10 eine Montageblechnut 23 für Montagebleche 52,53,54,55 (siehe FIG 11) auf.

Mit FIG 8 wird noch einmal in einer Detaildarstellung das eingesteckte erste Eckelement 31 in die erste Ecke A verdeutlicht. Auf die Fläche F wird später eine Dichtung 50 und eine Klebefläche 51 zu liegen kommen. Das eingesteckte Eckelement 31 dient mit seinem Elementkopf 43 dem sauberen bündigen Verschließen des durch das Ausfräsen geschaffenen Freiraum 11 im Rahmenprofil 10.

FIG 9 zeigt zur Verdeutlichung die eingelegte Dichtung 50 in die erste Ecke A. Die Dichtung 50 schmiegt sich an den durch das Band 20 gebildeten oberen Umfangskragen 20a an und dadurch wird ein Zwischenraum zwischen der Fläche F und einer später eingelegten Berührfläche 60 mittels der Dichtung 50 abgedichtet.

FIG 10 zeigt ein Ein- und Ausgabegerät 100 in einer geschnittenen Darstellung. Für eine Wandmontage oder eine Montage in einem Pult innerhalb eines Einbauausschnittes weist der Rahmen 1 an seinem unteren Umfangsragen 20a eine weitere Dichtung 56 auf. Auf die Fläche F des Rahmens 1 wird die Dichtung 50 und eine Klebefläche 51 aufgebracht, auf die die Berührfläche 60 geklebt wird. Unter der Berührfläche 60 ist ein Display 61 angeordnet, wodurch ein Touch Screen Display gebildet ist.

FIG 11 zeigt einen weiteren Vorteil des Rahmenprofils 10, da das Rahmenprofil 10 eine zusätzlich umlaufende Montageblechnut 23 aufweist, können in der Montageblechnut 23 ein erstes Montageblech 52, ein zweites Montageblech 53, ein drittes Montageblech 54 und ein viertes Montageblech 55 angeordnet werden. Die Montagebleche 52,53,54 und 55 sind in der Mitte zusammengeführt und dienen als ein Träger für eine Flachbaugruppe.

## Patentansprüche

1. Rahmen (1) für ein Ein- und Ausgabegerät (100) mit vier Ecken (A,B,C,D), bestehend aus einem einstückig ausgebildeten Rahmenprofil (10), welches einen ersten Schenkel (S1) und einen zweiten Schenkel (S2) aufweist, wobei
- am ersten Schenkel (S1) ein Band (20) angeordnet ist, und wobei in dem Rahmenprofil (10) zur Ausbildung der vier Ecken (A,B,C,D) Freiräume (11,12,13,14) derart angeordnet sind, dass das Band (20) im Bereich der Freiräume (11,12,13,14) stehen bleibt, und
- am zweiten Schenkel (S2) eine Nut (21) angeordnet ist,
wobei in den Ecken (A,B,C,D) jeweils ein Eckelement (31,32, 33,34) angeordnet ist,
**gekennzeichnet dadurch dass**
das Eckelement (31, 32, 33, 34) einen Elementkörper (40) mit einem ersten Elementschenkel (41) und einem zweiten Elementschenkel (42) aufweist, wobei die Elementschenkel (41,42) im Wesentlichen rechtwinklig zueinander am Elementkörper (40) angeordnet sind und die Eckelemente (31,32,33,34) derart in den Freiräumen (11,12,13,14) angeordnet sind, das der erste Elementschenkel (41) und der zweite Elementschenkel (42) jeweils in der Nut (21) des Rahmenprofils (10) angeordnet sind.

2. Rahmen (1) nach Anspruch 1, wobei die Elementschenkel (41, 42) an einem unteren Ende (44) des Elementkörpers (40) und ein Elementkopf (43) an einem oberen Ende (45) des Elementkörpers (40) angeordnet ist, dabei ist der Elementkopf (43) derart ausgestaltet, dass er den Freiraum (11,12,13,14) in den Ecken (A,B,C,D) derart verschließt, dass auf dem ersten Schenkel (S1) innerhalb des Rahmens (1) eine ebene Fläche (F) zum Aufbringen einer Dichtung (50) und oder Klebefläche (51) zum späteren Einsetzen einer Berührfläche (60) vorhanden ist.

3. Rahmen (1) nach einem der Ansprüche 1 oder 2, wobei das Band (20) als ein oberer Umfangskragen (20a) für den Rahmen (1) ausgestaltet ist und in diesem oberen Umfangskragen (20a) ist die Dichtung (50) angeordnet, welche den Zwischenraum zwischen der Fläche (F) des ersten Schenkels (S1) und einer Randfläche der später einsetzbaren Berührfläche (60) abdichtet.

4. Rahmen (1) nach einem der Ansprüche 1 bis 3, wobei das Band (20) als unterer Umfangskragen (20b) für den Rahmen (1) ausgestaltet ist und in diesem unteren Umfangskragen (20b) eine weitere Dichtung (56) angeordnet ist, welche den Zwischenraum zwischen einer unteren Fläche des ersten Schenkels (S1) und einer Randfläche eines Einbauausschnittes abdichtet.

5. Rahmen (1) nach Anspruch 3, wobei im zweiten Schenkel (S2) eine Halte-Nut (22) mit Hinterschneidung angeordnet ist, die derart ausgestaltet ist, dass darin eine Klemme (62) für einen Einbau in einem Einbauausschnitt zu befestigen ist.

6. Rahmen (1) nach einem der Ansprüche 1 bis 5, wobei das Rahmenprofil (10) aus einem Aluminium-Stranggussprofil gebildet ist.

7. Ein- und Ausgabegerät (100) für den industriellen Einsatzmit einem Rahmen (1) nach einem der Ansprüche 1 bis 6.

8. Verfahren zur Herstellung eines Rahmens (1) für ein Ein- und Ausgabegerät (100), wobei ein Rahmenprofil (10) verwendet wird, welches einen ersten Schenkel (S1) und einen zweiten Schenkel (S2) aufweist, wobei am ersten Schenkel (S1) ein Band (20) und am zweiten Schenkel (S2) eine Nut (21) angeordnet ist, wobei
in einem ersten Schritt:
- eine Länge (l), welche dem späteren Umfang des Rahmens (1) entspricht, von einem Rahmenprofil (10) abgelängt wird, und in einem zweiten Schritt:
- entsprechend der späteren Seitenlängen (l1, l2, l3, l4) des Rahmens (1) werden in das Rahmenprofil (10) zur Ausbildung der vier Ecken (A,B,C,D) Freiräume (11,12,13,14) derart eingebracht, dass das Band (20) im Bereich der durch die Freiräume (11,12,13,14) entstandenen Ausschnitte stehen bleibt, die Größe der Freiräume (11,12,13,14) wird dabei derart gewählt, dass ein im nächsten Schritt erforderliches Überbiegen störungsfrei gelingen kann, in einem dritten Schritt:
- werden an den Stellen der Freiräume (11,12,13,14) die Ecken (A,B,C,D) gebogen, dabei werden die jeweils an einer Ecke (A,B,C,D) anliegenden Seiten (a,b,c,d) leicht über einen Winkel von 90° Grad überbogen, um eine Restspannung im Material zu überwinden und damit ein Rückfedern der Seiten (a,b,c,d) zu verhindern, in einem vierten Schritt wird dann
- in den Ecken (A,B,C,D) jeweils ein Eckelement (31,32,33, 34) eingesetzt, wobei das Eckelement (31,32,33,34) einen Elementkörper (40) mit einem ersten Elementschenkel (41) und einem zweiten Elementschenkel (42) aufweist, wobei die Elementschenkel (41,42) im Wesentlichen rechtwinklig zueinander am Elementkörper (40) angeordnet sind und die Eckelemente (31,32,33,34) derart in die Freiräume (11, 12, 13, 14) eingesetzt werden, dass der erste Elementschenkel (41) und der zweite Elementschenkel (42) jeweils in der Nut (21) des Rahmenprofils (10) angeordnet wird, anschließend wird
- ein verbleibender Stoß (35) zusammengeschweißt.

9. Verfahren nach Anspruch 8, wobei Eckelemente (31,32,33,34) verwendet werden, bei welchem die Elementschenkel (41,42) an einem unteren Ende (44) des Elementkörpers (40) und ein Elementkopf (43) an einem oberen Ende (45) des Elementkörpers (40) angeordnet sind, wobei der Elementkopf (43) derart in dem Freiraum (11,12,13,14) in den Ecken (A,B,C,D) platziert wird, dass er diesen bündig verschließt, damit auf dem ersten Schenkel (S1) innerhalb des Rahmens (1) eine ebene Fläche zum Aufbringen einer Dichtung (50) und oder Klebefläche (51) zum späteren Einsetzen einer Berührfläche (60) geschaffen wird.

## Claims

1. Frame (1) for an input and output device (100), comprising four corners (A,B,C,D),
consisting of a frame profile (10) embodied in one piece, which has a first leg (S1) and a second leg (S2), wherein
- a strip (20) is arranged on the first leg (S1), and wherein open spaces (11,12,13,14) are arranged in the frame profile (10) to form the four corners (A,B,C,D) in such a manner that the strip (20) is left standing in the region of the open spaces (11,12,13,14), and
- a groove (21) is arranged on the second leg (S2),
wherein a corner element (31,32,33,34) is arranged in each of the corners (A,B,C,D), **characterised in that** the corner element (31,32,33,34) has an element body (40) with a first element leg (41) and a second element leg (42), wherein the element legs (41,42) are arranged substantially at right angles to one another on the element body (40) and the corner elements (31,32,33,34) are arranged in the open spaces (11,12,13,14) in such a manner that the first element leg (41) and the second element leg (42) are each arranged in the groove (21) of the frame profile (10).

2. Frame (1) according to claim 1, wherein the element legs (41, 42) are arranged at a lower end (44) of the element body (40) and an element head (43) is arranged at an upper end (45) of the element body (40), in which case the element head (43) is embodied in such a manner that it closes off the open space (11,12,13,14) in the corners (A,B,C,D) such that a flat surface (F) is present on the first leg (S1) within the frame (1) for applying a seal (50) and/or adhesive surface (51) for the subsequent introduction of a contact surface (60).

3. Frame (1) according to one of claims 1 or 2, wherein the strip (20) is embodied as an upper circumferential collar (20a) for the frame (1) and the seal (50), which seals off the intermediate space between the surface (F) of the first leg (S1) and a boundary surface of the contact surface (60) to be subsequently introduced, is arranged in said upper circumferential collar (20a).

4. Frame (1) according to one of claims 1 to 3, wherein the strip (20) is embodied as a lower circumferential collar (20b) for the frame (1) and a further seal (56), which seals off the intermediate space between a lower surface of the first leg (S1) and a boundary surface of an installation cutout, is arranged in said lower circumferential collar (20b).

5. Frame (1) according to claim 3, wherein a retaining groove (22) with an indentation is arranged in the second leg (S2), which is embodied such that a clamp (62) for installation in an installation cutout is to be fastened therein.

6. Frame (1) according to one of claims 1 to 5, wherein the frame profile (10) is formed by an aluminium continuous casting profile.

7. Input and output device (100) for industrial use, comprising a frame (1) according to one of claims 1 to 6.

8. Method for manufacturing a frame (1) for an input and output device (100), wherein a frame profile (10) is used which has a first leg (S1) and a second leg (S2), wherein a strip (20) is arranged on the first leg (S1) and a groove (21) is arranged on the second leg (S2), wherein
in a first step:
- a length (l), which corresponds to the subsequent circumference of the frame (1), is cut to length by a frame profile (10), and in a second step:
- according to the subsequent side lengths (11,12,13,14) of the frame (1), open spaces (11,12,13,14) are introduced into the frame profile (10) to form the four corners (A,B,C,D) in such a manner that the strip (20) is left standing in the region of the cutouts resulting from the open spaces (11,12,13,14), in which case the size of the open spaces (11,12,13,14) is chosen in such a manner that an overbending required in the subsequent step can succeed without interference, in a third step:
- the corners (A,B,C,D) are bent at the points of the open spaces (11,12,13,14), in which case the sides (a,b,c,d) adjoining a corner (A,B,C,D) are overbent slightly beyond an angle of 90° in order to overcome a residual stress in the material and thus to prevent the sides (a,b,c,d) from springing back, in a fourth step:
- a corner element (31,32,33,34) is then arranged in each of the corners (A,B,C,D), wherein the corner element (31,32,33,34) has an element body (40) with a first element leg (41) and a second element leg (42), wherein the element legs (41,42) are arranged substantially at right angles to one another on the element body (40) and the corner elements (31,32,33,34) are arranged in the open spaces (11,12,13,14) in such a manner that the first element leg (41) and the second element leg (42) are each arranged in the groove (21) of the frame profile (10), afterwards
- a remaining impact face (35) is welded together.

9. Method according to claim 8, wherein corner elements (31,32,33,34) are used, in which the element legs (41,42) are arranged at a lower end (44) of the element body (40) and an element head (43) is arranged at an upper end (45) of the element body (40), wherein the element head (43) is placed in the corners (A,B,C,D) in the open space (11,12,13,14) in such a manner that it closes this off flushly, meaning that a flat surface is created on the first leg (S1) within the frame (1) for applying a seal (50) and/or adhesive surface (51) for the subsequent introduction of a contact surface (60).

## Revendications

1. Cadre (1) d'un appareil (100) d'entrée et de sortie, comprenant quatre coins (A, B, C, D),
consistant en un profilé (10) de cadre constitué d'une seule pièce, qui a une première branche (S1) et une deuxième branche (S2), dans lequel
- sur la première branche (S1) est monté un ruban (20) et dans lequel, dans le profilé (10) de cadre, sont, pour la constitution des quatre coins (A, B, C, D), prévus des espaces (11, 12, 13, 14) libres, de manière à ce que le ruban (20) subsiste dans la région des espaces (11, 12, 13, 14) libres, et
- sur la deuxième branche (S2) est prévu une rainure (21), dans lequel, dans les coins (A, B, C, D), est disposé respectivement un élément (31, 32, 33, 34) de coin,
**caractérisé en ce que**
l'élément (31, 32, 33, 34) de coin a un corps (40) d'élément ayant une première branche (41) d'élément et une deuxième branche (42) d'élément, les branches (41, 42) d'élément étant disposées sensiblement à angle droit l'une par rapport à l'autre sur le corps (40) d'élément et les éléments (31, 32, 33, 34) de coin sont disposés dans les espaces (11, 12, 13, 14) libres, de manière à ce que la première branche (41) d'élément et la deuxième branche (42) d'élément soient disposées chacune dans la rainure (21) du profilé (10) de cadre.

2. Cadre (1) suivant la revendication 1, dans lequel les branches (41, 42) d'élément sont disposées à une extrémité (44) inférieure du corps (40) d'élément et une tête (43) d'élément est disposée à une extrémité (45) supérieure du corps (40) d'élément, la tête (43) d'élément étant conformée de manière à fermer l'espace (11, 12, 13, 14) libre dans les coins (A, B, C, D) de façon à avoir, sur la première branche (S1) à l'intérieur du cadre (1), une surface (F) plane pour le dépôt d'une étanchéité (50) et ou d'une surface (51) de collage pour l'insertion ultérieure d'une surface (60) tactile.

3. Cadre (1) suivant l'une des revendications 1 ou 2, dans lequel le ruban (20) est conformé sous la forme d'un collet (20a) périphérique supérieur pour le cadre (1) et, dans ce collet (20a) périphérique supérieur, est disposée l'étanchéité (50), qui rend étanche l'espace intermédiaire entre la surface (F) de la première branche (S1) et une surface de bord de la surface (60) tactile pouvant être insérée ultérieurement.

4. Cadre (1) suivant l'une des revendications 1 à 3, dans lequel le ruban (20) est conformé sous la forme d'un collet (20b) périphérique inférieur pour le cadre (1) et, dans ce collet (20b) périphérique inférieur, est disposée une autre étanchéité (56), qui rend étanche l'espace intermédiaire entre une surface inférieure de la première branche (S1) et une surface de bord d'une entaille de montage.

5. Cadre (1) suivant la revendication 3, dans lequel, dans la deuxième branche (S2), est disposée une rainure (22) de maintien à contre-dépouille, qui est conformée de manière à pouvoir y fixer une pince (62) pour un montage dans une entaille de montage.

6. Cadre (1) suivant l'une des revendications 1 à 5, dans lequel le profilé (10) de cadre est formé d'un profilé de coulée continue en aluminium.

7. Appareil (100) d'entrée et de sortie pour l'utilisation industrielle avec un cadre (1) suivant l'une des revendications 1 à 6.

8. Procédé de fabrication d'un cadre (1) d'un appareil (100) d'entrée et de sortie, dans lequel on utilise un profilé (10) de cadre, qui a une première branche (S1) et une deuxième branche (S2), un ruban (20) étant monté sur la première branche (S1) et une rainure (21) étant prévue sur la deuxième branche (S2), dans lequel
dans un premier stade :
- on met à longueur un tronçon (1), qui correspond au pourtour ultérieur du cadre (1) d'un profilé (10) de cadre, et dans un deuxième stade :
- conformément au tronçon (11, 12, 13, 14) ultérieur des côtés du cadre (1), on ménage, dans le profilé (10) de cadre pour la constitution des quatre coins (A, B, C, D), des espaces (11, 12, 13, 14) libres, de manière à ce que le ruban (20) subsiste dans la région des entailles créées par les espaces (11, 12, 13, 14) libres, on choisit la dimension des espaces (11, 12, 13, 14) libres de manière à pouvoir obtenir sans difficulté un surfléchissement nécessaire au stade suivant, dans un troisième stade :
- on courbe aux points des espaces (11, 12, 13, 14) libres les coins (A, B, C, D), les côtés (a, b, c, d) s'appliquant respectivement à un coin (A, B, C, D) sont courbés légèrement au-delà d'un angle de 90° pour surmonter une tension résiduelle dans le matériau et empêcher ainsi une élasticité en retour des côtés (a, b, c, d), dans un quatrième stade ensuite :
- on insère, dans les coins (A, B, C, D), respectivement un élément (31, 32, 33, 34) de coin, l'élément (31, 32, 33, 34) de coin ayant un corps (40) d'élément ayant une première branche (41) d'élément et une deuxième branche (42) d'élément, les branches (41, 42) d'élément étant disposées sensiblement à angle droit entre elles sur le corps (40) d'élément et les éléments (31, 32, 33, 34) de coin étant insérés dans les espaces (11, 12, 13, 14) libres, de manière à ce que la première branche (41) d'élément et la deuxième branche (42) d'élément soient disposées respectivement dans la rainure (21) du profilé (10) de cadre, ensuite
- on joint par soudage un bord (35) restant.

9. Procédé suivant la revendication 8, dans lequel on utilise les éléments (31, 32, 33, 34) de coin, dans lequel les branches (41, 42) d'élément sont disposées à une extrémité (44) inférieure du corps (40) d'élément et une tête (43) d'élément est disposée à une extrémité (45) supérieure du corps (40) d'élément, dans lequel on place la tête (43) d'élément dans l'espace (11, 12, 13, 14) libre dans les coins (A, B, C, D), de manière à ce qu'elle les ferme à affleurement afin de ménager, sur la première branche (S1) dans le cadre (1), une surface plane pour le dépôt d'une étanchéité (50) et ou d'une surface (51) de collage pour l'insertion ultérieure d'une surface (60) tactile.
